(19) Europäisches Patentamt
European Patent Office
Office européen des brevets

(11) **EP 2 487 502 B1**

(12) **EUROPÄISCHE PATENTSCHRIFT**

(45) Veröffentlichungstag und Bekanntmachung des Hinweises auf die Patenterteilung:
**10.04.2019 Patentblatt 2019/15**

(51) Int Cl.:
***G01R 35/04*** *(2006.01)*

(21) Anmeldenummer: **11153965.6**

(22) Anmeldetag: **10.02.2011**

(54) **Elektronischer Stromzähler, Stromversorgungssystem und Verfahren zum Betrieb eines solchen**

Electronic electricity meter, power system and method for operating same

Compteur de courant électronique, système d'alimentation en courant et procédé de fonctionnement de celui-ci

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.08.2012 Patentblatt 2012/33**

(73) Patentinhaber: **EFR Europäische Funk-Rundsteuerung 80335 München (DE)**

(72) Erfinder: **Inan, Ali 91096 Möhrendorf (DE)**

(74) Vertreter: **Heinze, Ekkehard et al Meissner Bolte Patentanwälte Rechtsanwälte Partnerschaft mbB Widenmayerstraße 47 80538 München (DE)**

(56) Entgegenhaltungen:
**EP-A2- 0 240 102        EP-A2- 1 033 580
DE-A1-102007 046 921    DE-C1- 19 526 723
US-A1- 2008 046 205     US-B1- 6 735 535**

**Beschreibung**

Die Erfindung betrifft einen elektronischen Stromzähler sowie ein Stromversorgungssystem und ein Verfahren zur Betrieb eines solchen.

Zählereinrichtungen zur Erfassung des (privaten oder gewerblichen) Verbrauchs an elektrischer Energie, die in einem Stromversorgungsnetz zur Verfügung gestellt wird, (kurz bezeichnet als "Stromzähler") sind seit Jahrzehnten bekannt und im Einsatz. Die in deutschen und weitgehend auch europäischen Privathaushalten genutzten Stromzähler zur Verbrauchsabrechnung erfassen den Wirkstrom sowie die Momentan-Wechselspannung und führen anschließend eine Multiplikation und zeitliche Integration durch und arbeiten auf der Basis des Induktionsmotor-Prinzips.

Der Einsatz von elektronischen Zählern bei Haushalten als Massenprodukt steht durch die "Smart-Metering-Initiative" europaweit unmittelbar bevor. Für die elektronischen Zähler gilt jedoch derzeit eine Eichgültigkeitsdauer von 8 Jahren, wonach die betroffene Population der Zäher einer Stichprobe zu unterziehen ist. Dieser Nachteil gegenüber der elektromechanisch arbeitenden Zählern nach dem Induktionsmotor-Prinzip, deren Eichgültigkeitsdauer 16 Jahre beträgt, ist im Wesentlichen auf die Alterung und die geringere Robustheit von elektronischen Komponenten zurückzuführen.

Darüber hinaus fehlt es an Langzeiterfahrungen mit den elektronischen Haushaltszählern, um statistische Aussagen über deren Messrichtigkeit und damit Einhaltung von Eichfehlergrenzen treffen zu können.

Der Erfindung liegt die Aufgabe zugrunde, einen elektronischen Stromzähler bereitzustellen, mit dem sich der hohe organisatorische und Auswertungs-Aufwand einer Überprüfung der Mess-Richtigkeit umfangreicher Stichproben von massenhaft installierten Zählern vermeiden lässt.

Diese Aufgabe wird durch einen elektronischen Stromzähler mit den Merkmalen des Anspruchs 1 gelöst. Des Weiteren wird ein Stromversorgungssystem mit den Merkmalen des Anspruchs 2 sowie ein Verfahren zum Betrieb eines solchen mit den Merkmalen des Anspruchs 5 bereitgestellt.

Ein wesentlicher Gedanke der Erfindung ist es, die Richtigkeit der Messung von elektronischen Vierleiter-Zählern durch eine redundante, aufwandsarme Messung der Leistung über deren gesamte Einsatzdauer zu verifizieren. Auf diese Weise lassen sich elektronische Zähler hinsichtlich ihrer Eichgültigkeit einzeln selbst beurteilen. Nachhaltige Verletzungen von Eichfehlern werden von solchen Zählern aktiv erkannt. Die Geräte setzen sich dann gegebenenfalls selbsttätig außer Betrieb. Der im Gerät gespeicherte fehlerhafte Zustand kann spätestens bei der nächsten Visite bzw. Ablesung erfasst oder ggf, über eine vorhandene Kommunikationsstrecke unmittelbar zu einer zentralen Instanz gemeldet werden.

Mit der Selbsterkennung der Messrichtigkeit jedes einzelnen Gerätes kann folglich auf das Stichprobenverfahren einer Zählerpopulation grundsätzlich verzichtet werden. Es ergeben sich mit der vorliegenden Erfindung bei der künftigen flächendeckenden Ausrüstung von Stromversorgungssysteme mit elektronischen Zählern also erhebliche logistische und wirtschaftliche Vorteile,

Die Erkennung und Verifizierung der Messrichtigkeit basiert insbesondere auf der Verwendung von redundanten Messgrößen im Drehstromsystem und dem *"Prinzip von zwei Gleichungen",* wobei zunächst eine qualitative und abschließend eine quantitative Aussage getroffen werden.

Zur Messung der Leistung eines Drehstromsystems sind folgende Größen heranzuziehen, die in elektronischen Zählern messtechnisch über Sensoren erfasst werden:

- Leiterströme $i_{L1}(t)$, $i_{L2}(t)$ und $i_{L3}(t)$

- Leiterspannungen $u_{L1}(t)$, $u_{L2}(t)$ und $u_{L3}(t)$

Mit den quantisierten Messwerten wird die Wirkleistung nach der Gleichung ihrer Definition berechnet:

$$P(t) = \int_t^{t+kT} u_{L1}(t) i_{L1}(t)\, dt + u_{L2}(t) i_{L2}(t)\, dt + u_{L3}(t) i_{L3}(t)\, dt \qquad [1.1]$$

Etwaige Abweichungen der tatsächlichen Messwerte, die in der gesamten Verarbeitungskette von der Erfassung bis zur Ausgabe des errechneten Ergebnisses auf Grund von internen Fehlern bei den Bauteilen bzw. Komponenten auftreten können, bleiben stets unerkannt. Deren Einfluss auf das Endergebnis, d.h. die berechnete Wirkleistung, lässt sich folglich nicht ermitteln.

Aus diesem Grunde wird vorgeschlagen, in den Zählern folgende Messgrößen zusätzlich zu erfassen und zur Selbstverifizierung der Messrichtigkeit heranzuziehen:

- Neutralleiterstrom $i_N(t)$

- Leiter-Leiterspannungen $u_{L1L2}(t)$ und $u_{L3L1}(t)$

Überprüft man die Erfüllung der Kirchhoffschen Gesetze in den Außenleitern, so müssen folgende Gleichungen in Summe stets null ergeben:

$$i_{L1}(t) + i_{L2}(t) + i_{L3}(t) + i_N(t) = 0 \qquad [2.1]$$

$$u_{L1L2}(t) + u_{L3L1}(t) + u_{L2}(t) - u_{L3}(t) = 0 \qquad [2.2]$$

Da die Messwerte in den obigen Gleichungen intern umgewandelt sind, so würden etwaige Abweichungen von den tatsächlichen Messgrößen in den Strom- und Spannungskreisen dazu führen, dass die Gleichungen [2.1], [2.2] jeweils einen Differenzbetrag $\Delta i$ bzw. $\Delta u$ ergeben:

$$i_{L1}(t) + i_{L2}(t) + i_{L3}(t) + i_N(t) = \Delta i \leq \varepsilon_i \qquad [2.3]$$

$$u_{L1L2}(t) + u_{L3L1}(t) + u_{L2}(t) - u_{L3}(t) = \Delta u \leq \varepsilon_u \qquad [2.4]$$

Der Vergleich der Differenzbeträge für Strom oder Spannung mit den festzulegenden Grenzwerten $\varepsilon_i$ und $\varepsilon_u$ lässt interne Fehler in der gesamten Verarbeitungskette qualitativ erkennen. Um die Messrichtigkeit quantitativ zu ermitteln, wird die Wirkleistung mit gemischten Messgrößen aus den Hauptmessgrößen und zusätzlich erfassten Messgrößen nach folgender Gleichung berechnet:

$$P'(t) = \int_t^{t+kT} -u_{L1}(t)\, i_N(t)dt + u_{L1L2}(t)i_{L2}(t)\, dt + u_{L3L1}(t)i_{L3}(t)dt \quad [1.2]$$

Die Mischung der Hauptmessgrößen mit den zusätzlich erfassten Messgrößen in [1.2] stellt sicher, dass die internen Fehler in allen Strom- und Spannungskreisen sich im Ergebnis ΔP bemerkbar machen würden derart, dass gilt

$$P(t) - P'(t) = \Delta P \geq \varepsilon_p \qquad [1.3]$$

Der Differenzbetrag ΔP entspricht dabei dem Einfluss des Fehlers im Strom $\Delta i$ und/oder der Spannung $\Delta u$. Der Parameter $\varepsilon_p$ muss so festgelegt werden, dass dessen Überschreitung unter Einhaltung der Toleranzen zur Verletzung der Eichfehlergrenzen führt.

Hieraus ergibt sich, dass in einer Ausführung der Erfindung die Verarbeitungsmittel einen ersten Schwellwert-Diskriminator zum Erfassen der Unter- oder Überschreitung eines vorbestimmten Schwellenwertes der Differenz zwischen einem Messsignal der bestimmungsgemäßen Messfunktion und verarbeiteten Messsignalen der Verifizierungs-Messmittel und zur Ausgabe eines von einem ersten und einem zweiten Verifizierungssignal aufweisen.

In einer weiteren Ausführung der Erfindung umfassen die Verifizierungs-Messmittel Strom-Messmittel, insbesondere einen Nebenschlusswiderstand, zur Erfassung des Neutralleiterstroms sowie erste und zweite Spannungs-Messmittel, insbesondere Widerstandsteiler, zur Erfassung der Leiter-Leiter-Spannungen der stromführenden Leiter eines Vierleiter-Systems.

Insbesondere ist in den Verarbeitungsmitteln ein Entscheidungsalgorithmus zur gemeinsamen Verarbeitung der Ausgangssignale des ersten Schwellwert-Diskriminators und der beiden zweiten Schwellwert-Diskriminatoren zur Ausgabe des ersten oder zweiten Verifizierungssignals gespeichert.

Insgesamt umfasst der Verarbeitungs-Ablauf bevorzugt folgende wesentliche Stufen/Schritte:

- theoretische Stimulation von Fehlern in den Messgrößen;
- quantitative Berechnung des Fehlers in der Wirkleistung bei symmetrischem Drehstromsystem mit sinusförmigen Signalen;
- quantitative Berechnung des Fehlers in der Wirkleistung bei Asymmetrien und bei Harmonischen durch numerische Verfahren;

- Ermittlung/Festlegung der geeigneten Parameter $\varepsilon_i$, $\varepsilon_u$ und $\varepsilon_p$;
- Nachweis der Gültigkeit des Algorithmus bei Fehlern in allen Strom- und Spannungskreisen der Vierleiter-Drehstromzähler.

Zur rechnerischen Nachvollziehbarkeit wird empfohlen, die Fehlersimulationen zunächst am Beispiel eines vereinfachten Rechenmodells vorzunehmen. Dazu wird angenommen, dass das Drehstromsystem im stationär symmetrischeren Zustand mit sinusförmigen Signalen gegeben sei, wobei gilt:

$$i_{L1}(t) = I_{L1}\ sin(\omega t + \varphi_{L1i})$$

$$i_{L2}(t) = I_{L2}\ sin(\omega t + 120° + \varphi_{L2i})$$

$$i_{L3}(t) = I_{L3}\ sin(\omega t - 120° + \varphi_{L3i})$$

$$u_{L1}(t) = U_{L1}\ sin(\omega t + \varphi_{L1u})$$

$$u_{L2}(t) = U_{L2}\ sin(\omega t + 120° + \varphi_{L2u})$$

$$u_{L3}(t) = U_{L3}\ sin(\omega t - 120° + \varphi_{L3iu})$$

Zur Fehlersimulation kann nun in einem Strompfad eine Differenzgröße $\Delta i(t)$ überlagert werden, die in Amplitude und Phase veränderlich ist. Im symmetrischen System macht sich dieser Strom im Neutralleiter bemerkbar. Ähnlich ist in einem der Spannungskreise die Differenzgröße $\Delta u(t)$ als Fehleranteil anzunehmen.

Im fehlerfreien Fall ergibt sich mit den oben definierten Strömen und Spannungen für die Wirkleistung [1.1]:

$$P = U_{L1}I_{L1}\cos\varphi_1 + U_{L2}I_{L2}\cos\varphi_2 + U_{L3}I_{L3}\cos\varphi_3 \qquad [3.1]$$

und für die Wirkleistung [1.2] sinngemäß:

$$P' = U_{L1L2}I_{L2}\cos\varphi_{12} + U_{L3L1}I_{L3}\cos\varphi_{31} - U_{L1}I_N\cos\varphi_{1N} \qquad [3.2]$$

Dabei gilt für den Phasenwinkel der Komponente L1: ($\varphi_1 = \varphi_{L1u} - \varphi_{L1i}$, was exemplarisch für den Phasenwinkel anderer Komponente auch gilt.

In einer Ausführung des vorgeschlagenen Stromversorgungssystems ist in den Stromzählern eine Sendeeinheit zum Aussenden der Verifizierungssignale und bei der zentralen Datenspeichereinheit eine Empfangseinheit zum Empfang der Verifizierungssignale, insbesondere in Echtzeit oder Quasi-Echtzeit, vorgesehen. Natürlich ist es auch möglich, die Prüfdaten der erfindungsgemäßen Stromzähler mit mobilen Ablesegeräten, die nicht unmittelbar den einzelnen Zählern zugeordnet sind, zur zentralen Datenspeichereinheit zu bringen.

In einer weiteren Ausführung, die vorteilhaft mit der vorgenannten kombinierbar, aber nicht von deren Realisierung abhängig ist, ist der zentralen Datenspeichereinheit eine Anzeigeeinheit, insbesondere mit Alarm-Anzeigefunktion, zur zählerspezifischen Anzeige des ausgegebenen Verifizierungssignals, insbesondere im Ansprechen auf ein die Unkorrektheit der bestimmungsgemäßen Messfunktion angebendes Verifizierungssignal, zugeordnet.

Verfahrensaspekte der Erfindung, sowohl bezüglich des einzelnen Stromzählers als auch des Stromversorgungssystems, ergeben sich aus den o. g. Geräte- bzw. Systemmerkmalen und werden hier nicht wiederholt.

Vorteile und Zweckmäßigkeiten der Erfindung ergeben sich im Übrigen aus der nachfolgenden Beschreibung von Ausführungsbeispielen bzw. -aspekten der Erfindung anhand der Figuren. Von diesen zeigen:

Fig. 1 eine schematische Darstellung von in einem Ausführungsbeispiel des erfindungsgemäßen Stromzählers eingesetzten Mess- und Rechenmitteln,

Fig. 2 eine schematische Darstellung von in einem Ausführungsbeispiel des erfindungsgemäßen Stromzählers eingesetzten Auswertungsmitteln und

Fig. 3 eine schematische Darstellung einer Ausführungsform des erfindungsgemäßen Stromversorgungssystems.

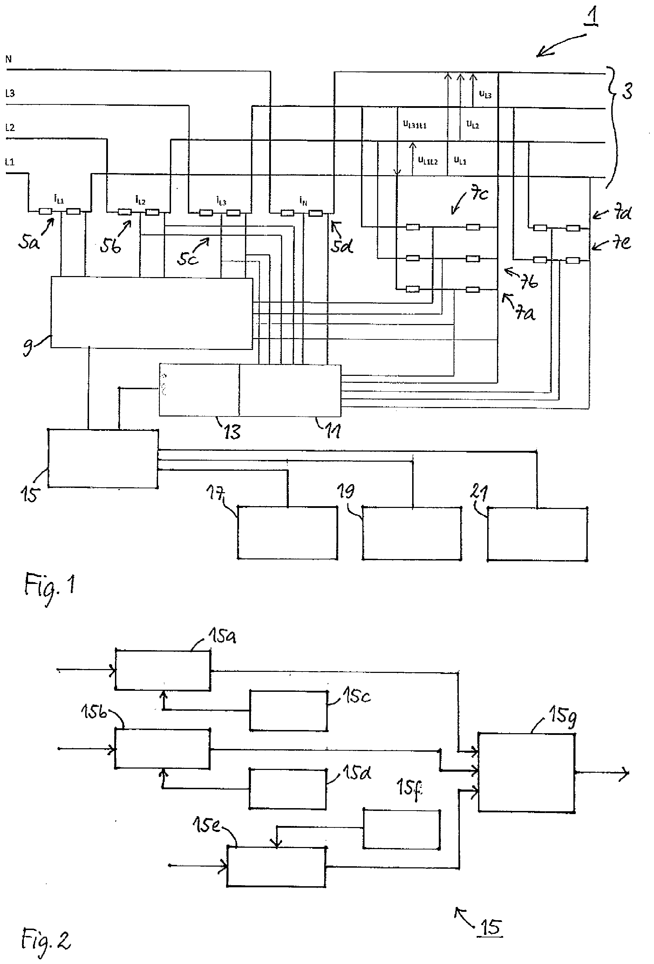

Fig. 1 zeigt schematisch in Form eines Blockschaltbildes wesentliche Komponenten eines elektronisches Stromzählers 1 zum Einsatz an einem Vierleiter-Stromversorgungssystem 3. Der Stromzähler 1 umfasst Strom-Messmittel 5a bis 5c zur Erfassung der Leiterströme $i_{L1}$, $i_{L2}$ und $i_{L3}$ sowie zusätzlich Strom-Messmittel 5d zur Erfassung des Neutralleiterstroms $i_N$. Des Weiteren umfasst er Spannungs-Messmittel 7a bis 7c zur Messung der Leiterspannungen $U_{L1}$, $U_{L2}$ und $U_{L3}$ sowie zusätzliche Spannungs-Messmittel 7d und 7e zur Messung der Leiter-Leiter-Spannungen $U_{L1L2}$ bzw. $U_{L3L1}$, wobei die Letzteren jeweils einen Widerstandsteiler umfassen.

Die üblicherweise bei Stromzählern vorhandenen Strom-Messmittel 5a bis 5c sowie die Widerstandsteiler-Abgriffspunkte der üblicherweise vorhandenen Spannungs-Messmittel 7a bis 7c sind mit entsprechenden Eingängen eines Hauptrechenwerks 9 und zusätzlich mit Eingängen eines Multiplexer 11 verbunden, der einem Hilfs-Rechenwerk 13 vorgeschaltet ist. Mit weiteren Eingängen des Multiplexers 11 sind außerdem die zusätzlichen Strom-Messmittel 5d zur Messung des Neutralleiterstroms und die zusätzlichen Spannungs-Messmittel 7d, 7e zur Messung der Leiter-Leiter-Spannungen verbunden.

In den Rechenwerken (Mikroprozessoranordnen) 9, 13 sowie einer nachgeschalteten Auswertungs-/Entscheidungsstufe 15 findet eine Messwertverarbeitung und Auswertung gemäß den oben erläuterten Prinzipien statt, die in der Ausgabe eines Verifizierungssignals durch die Auswertungs-/Entscheidungsstufe 15 mündet, das einer Speichereinheit 17 zu dessen Speicherung und/oder einer Sendeeinheit 19 zu dessen Aussendung und/oder einer internen Steuereinheit 21 des Stromzählers zum Bewirken eines Steuervorgangs (z.B. seiner Deaktivierung bei unzulässig großer Messwertabweichung) zugeführt wird.

Fig. 2 zeigt schematisch einen Abschnitt der Auswertungs-/Entscheidungsstufe 15 des Stromzählers 1 aus Fig. 1. Dieser Abschnitt umfasst zwei Schwellwert-Diskriminatoren 15a, 15b zum Erfassen der Unter- oder Überschreitung eines vorbestimmten Schwellenwertes von $\Delta i$ gemäß obiger Gleichung [2.3] bzw. $\Delta u$ gemäß obiger Gleichung [2.4], die einerseits mit einem Ausgang des Hilfs-Rechenwerks 13 und andererseits mit einem zugeordneten Schwellenwertspeicher 15c bzw. 15d verbunden sind. Weiterhin umfasst die Auswertungs-/Entscheidungsstufe 15 einen weiteren Schwellwert-Diskriminator 15e zur Erfassung der Unter- oder Überschreitung eines vorbestimmten Schwellenwertes der Differenz zwischen der aus den Hauptmessgrößen ermittelten Wirkleistung einerseits und der aus den Hilfsmessgrößen berechneten Wirkleistung andererseits, also dem Wert $\Delta P$ gemäß Gleichung [1.3] weiter oben. Diesem Schwellwert-Diskriminator ist ebenfalls ein Schwellenwertspeicher 15f zugeordnet.

Je nach Ausführung des Stromzählers können die Ausgangssignale der Schwellwert-Diskriminatoren wahlweise einzeln als geltendes Verifizierungssignal verwendet werden; bei der hier gezeigten Ausführung ist den genannten Schwellwert-Diskriminatoren aber eine Entscheidungsstufe 15g zur gemeinsamen Verarbeitung ihrer Ausgangssignale nachgeschaltet, welche letztlich das gültige Verifizierungssignal für die Richtigkeit (oder Unrichtigkeit) der Messungen des Stromzählers liefert. Neben der in Fig. 2 dargestellten Schwellenwert-Verarbeitung der intern im Stromzähler gewonnenen Prüfergebnisse sind auch andere Verarbeitung der Ergebnisse, speziell auch in der logischen Verknüpfung qualitativer und quantitativer Aussagen, möglich.

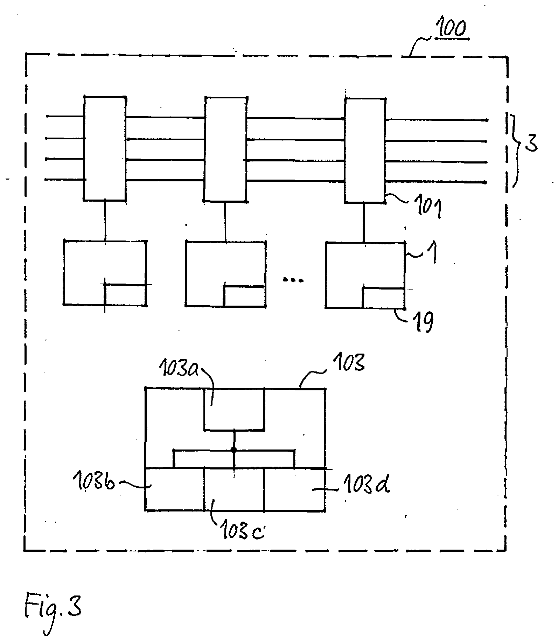

Fig. 3 zeigt schematisch die Einbindung von Stromzählern 1 der in Fig. 1 gezeigten und oben beschriebenen Art in ein Stromversorgungssystem 100 vom Vierleiter-Typ, welches eine Vielzahl von Verbrauchsstellen 101 mit Verbrauchserfassung hat und über eine Systemzentrale 103 überwacht und gesteuert wird. Es ist dargestellt, dass die Stromzähler 1 (wie bereits in Fig. 1 eingeführt) Sendeeinheiten 19 aufweisen, die mit Empfangseinheiten 103a bei der Systemzentrale kommunizieren. Dort sind sie mit Datenspeichereinheiten 103b, Anzeigeeinheiten 103c und zusätzlichen Alarmgebern 103d verbunden, die die Prüfergebnisse der einzelnen Zähleranzeigen und ggf. bei Überschreitung der Toleranzen (bzw. einem dadurch selbsttätig inizierten Abschalten eines Zählers) ein Alarmsignal darstellen.

Die Ausführung der Erfindung ist durch die Patentansprüche definiert und nicht auf dieses Beispiel und die oben erläuterten Aspekte der Erfindung beschränkt, sondern ebenso in einer Vielzahl von Abwandlungen möglich, die im Rahmen fachmännischen Handelns liegen.

## Patentansprüche

1. Elektronischer Stromzähler (1), welcher interne Verifizierungs-Messmittel und diesen eingangsseitig zugeordnete interne Verarbeitungsmittel aufweist, die für eine bestimmungsgemäße Messfunktion nicht erforderlich und derart ausgebildet sind, dass ein aus Messsignalen der Messmittel bestimmtes Verifizierungssignal die Korrektheit der bestimmungsgemäßen Messfunktion verifiziert oder nicht verifiziert, und eine den Verarbeitungsmitteln, die den Verifizierungs-Messmitteln zugeordnet sind, nachgeschaltete Speichereinheit zum Speichern des Verifizierungssignals und/oder Sendeeinheit zum Aussenden des Verifizierungssignals und/oder Steuereinheit zum Bewirken eines Steuervorgangs im Stromzähler in Abhängigkeit vom Verifizierungssignal umfasst, wobei die Verarbeitungsmittel einen ersten Schwellwert-Diskriminator (15e) zum Erfassen der Unter- oder Überschreitung eines vorbestimmten Schwellenwertes der Differenz zwischen einem Messsignal der bestimmungsgemäßen Messfunktion und den verarbeiteten Messsignalen der Verifizierungs-Messmittel aufweisen zur Bereitstellung eines Verifizierungssignals von einem ersten und einem zweiten Verifizierungssignal, wobei die Verifizierungs-Messmittel Strom-Messmittel (5a, 5b, 5c, 5d) umfassen, insbesondere einen Nebenschlusswiderstand, zur Erfassung der Leiterströme $i_{L1}(t)$, $i_{L2}(t)$, $i_{L3}(t)$ und des Neutralleiterstroms $i_N(t)$ sowie Spannungs-Messmittel (7a, 7b, 7c, 7d, 7e), insbesondere je einen Widerstandsteiler, zur Erfassung der Leiterspannungen $u_{L1}(t)$, $u_{L2}(t)$, $u_{L3}(t)$ und der Leiter-Leiter-Spannungen $u_{L1L2}(t)$, $u_{L3L1}(t)$ der stromführenden Leiter (L1, L2, L3) eines Vierleiter-Systems (3) und wobei in den Verarbeitungsmitteln ein Verarbeitungsalgorithmus nach dem "Prinzip von zwei Gleichungen" unter Verwendung der Messsignale der Strom-Messmittel und der Spannungs-Messmittel, und der Gleichungen für die Wirkleistung P(t), P(t):

$$P(t) = \int_t^{t+kT} u_{L1}(t) i_{L1}(t) dt + u_{L2}(t) i_{L2}(t) dt + u_{L3}(t) i_{L3}(t) dt \qquad [1.1]$$

$$P'(t) = \int_t^{t+kT} -u_{L1}(t) i_N(t) dt + u_{L1L2}(t) i_{L2}(t) dt + u_{L3L1}(t) i_{L3}(t) dt \qquad [1.2]$$

implementiert ist und der erste Schwellwert-Diskriminator zum Erfassen der Unter- oder Überschreitung eines vorbestimmten Schwellenwertes $\varepsilon_P$ für den Differenzbetrag $\Delta P$ aus beiden Gleichungen gemäß

$$P(t) - P'(t) = \Delta P \geq \varepsilon_p \qquad [1.3]$$

ausgebildet ist zur Bereitstellung des Verifizierungssignals von dem ersten und dem zweiten Verifizierungssignal in Abhängigkeit von der Unter- oder Überschreitung.

2. Stromversorgungssystem (100) mit einer Vielzahl von elektronischen Stromzählern (1) nach Anspruch 1 und einer zentralen Datenspeichereinheit zur Speicherung von in den Stromzählern gewonnenen Verifizierungssignalen in Zuordnung zu dem jeweiligen Stromzähler und dem Zeitpunkt ihrer Gewinnung.

3. Stromversorgungssystem nach Anspruch 2, wobei in den Stromzählern eine Sendeeinheit (19) zum Aussenden der Verifizierungssignale und bei der zentralen Datenspeichereinheit eine Empfangseinheit (103a) zum Empfang der Verifizierungssignale, insbesondere in Echtzeit oder Quasi-Echtzeit, vorgesehen ist.

4. Stromversorgungssystem nach Anspruch 2 oder 3, wobei der zentralen Datenspeichereinheit einer Anzeigeeinheit (103c), insbesondere mit Alarm-Anzeigefunktion, zur zählerspezifischen Anzeige des ausgegebenen Verifizierungssignals, insbesondere im Ansprechen auf ein die Unkorrektheit der bestimmungsgemäßen Messfunktion angebendes Verifizierungssignal, zugeordnet ist.

5. Verfahren zum Betrieb eines Stromversorgungssystems mit elektronischen Stromzählern, wobei in Ersetzung periodischer stichprobenartiger Eichmessungen an einzelnen Stromzählern eine kontinuierliche oder periodische interne Verifizierungs-Signalerfassung und -verarbeitung in sämtlichen Stromzählern ausgeführt wird und deren Ergebnisse intern gespeichert und/oder an eine Zentrale des Stromversorgungssystems gesandt und/oder zur Ausführung eines internen Steuervorgangs in den Stromzählern benutzt werden, wobei die interne Verifizierungs-Signalerfassung und -verarbeitung eine erste Schwellwert-Diskriminierung zum Erfassen einer Unter- oder Überschreitung eines vorbestimmten Schwellenwertes der Differenz zwischen einem Messsignal der bestimmungsgemäßen Messfunktion und verarbeiteten Messsignalen von Verifizierungs-Messmitteln umfasst zur Bereitstellung eines Verifizierungssignals von einem ersten und einem zweiten Verifizierungssignal, wobei das Stromversorgungssystem als Vierleiter-Versorgungssystem ausgeführt ist und die Verifizierungs-Signalerfassung die Messung der Leiterströme $i_{L1}(t)$, $i_{L2}(t)$, $i_{L3}(t)$ und des Neutralleiterstroms $i_N(t)$ und der Leiterspannungen $u_{L1}(t)$, $u_{L2}(t)$, $u_{L3}(t)$ und der beiden Leiter-Leiter-Spannungen $u_{L1L2}(t)$, $u_{L3L1}(t)$ umfasst und wobei ein Verarbeitungsalgorithmus nach dem "Prinzip von zwei Gleichungen" unter Verwendung der Messsignale der Strom-Messmittel und der Spannungs-Messmittel, und der Gleichungen für die Wirkleistung P(t), P(t):

$$P(t) = \int_{t}^{t+kT} u_{L1}(t)\, i_{L1}(t)\, dt + u_{L2}(t)i_{L2}(t)\, dt + u_{L3}(t)i_{L3}(t)\, dt \qquad [1.1]$$

$$P'(t) = \int_{t}^{t+kT} -u_{L1}(t)\, i_{N}(t)\, dt + u_{L1L2}(t)i_{L2}(t)\, dt + u_{L3L1}(t)i_{L3}(t)\, dt \qquad [1.2]$$

abgearbeitet wird und eine Schwellwert-Diskriminierung zum Erfassen der Unter- oder Überschreitung eines vorbestimmten Schwellenwertes $\varepsilon_P$ für den Differenzbetrag $\Delta P$ aus beiden Gleichungen gemäß

$$P(t) - P'(t) = \Delta P \geq \varepsilon_P \qquad [1.3]$$

ausgeführt wird zur Bereitstellung eines Verifizierungssignals von dem ersten und dem zweiten Verifizierungssignal in Abhängigkeit von der Unter- oder Überschreitung.

## Claims

1. An electronic electricity meter (1) which has internal verification measurement means and internal processing means assigned to them on the input side, which are not necessary for an intended measuring function and are formed such that a verification signal determined from measurement signals of the measurement means verifies or does not verify the correctness of the intended measuring function, and comprises a storage unit connected downstream of the processing means, which are assigned to the verification measurement means, for storing the verification signal, and/or a transmitting unit for emitting the verification signal, and/or a control unit for causing a control operation to be performed in the electricity meter depending on the verification signal, wherein the processing means have a first threshold discriminator (15e) for detecting the shortfall or excess of a predetermined threshold value of the difference between a measurement signal of the intended measuring function and the processed measurement signals of the verification measurement means for providing a verification signal among a first and a second verification signal, wherein the verification measurement means comprise current measurement means (5a, 5b, 5c, 5d), in particular a shunt resistor for detecting the conductor currents $i_{L1}(t)$, $i_{L2}(t)$, $i_{L3}(t)$ and the neutral conductor current $i_N(t)$, as well as voltage measuring means (7a, 7b, 7c, 7d, 7e), in particular in each case a resistance divider for detecting the conductor voltages $u_{L1}(t)$, $u_{L2}(t)$, $u_{L3}(t)$ and the conductor-to-conductor voltages $u_{L1L2}(t)$, $u_{L3L1}(t)$ of the current-conducting conductors (L1, L2, L3) of a four conductor system (3), and wherein, in the processing means, a processing algorithm based on the "principle of two equations" is implemented using the measurement signals of the current measuring means and the voltage measuring means and the equation for the active power P(t), P'(t):

$$P(t) = \int_{t}^{t+kT} u_{L1}(t)\, i_{L1}(t)\, dt + u_{L2}(t)i_{L2}(t)\, dt + u_{L3}(t)i_{L3}(t)\, dt \qquad [1.1]$$

$$P'(t) = \int_{t}^{t+kT} -u_{L1}(t)\, i_{N}(t)\, dt + u_{L1L2}(t)i_{L2}(t)\, dt + u_{L3L1}(t)i_{L3}(t)\, dt \qquad [1.2]$$,

and the first threshold discriminator is configured to detect the shortfall or excess of a predetermined threshold value $\varepsilon_P$ for the differential amount $\Delta P$ from both of the equations according to

$$P(t) - P'(t) = \Delta P \geq \varepsilon_P \qquad [1.3]$$

for providing the verification signal among the first and the second verification signal depending on the shortfall or excess.

2. A power supply system (100) having a plurality of electronic electricity meters (1) according to claim 1 and a central data storage unit for storing of verification signals obtained within the electricity meters in association with the respective electricity meter and the time of their obtention.

3. The power supply system according to claim 2, wherein a transmitting unit (19) for emitting the verification signals is provided in the electricity meters, and a receiving unit (103a) for receiving the verification signals, in particular in real time or virtually real time is provided at the central data storage unit.

4. The power supply system according to claim 2 or 3, wherein a display unit (103c), in particular having an alarm display function, for a meter-specific display of the output verification signal, in particular in response to a verification signal indicating the incorrectness of the intended measuring function, is associated to the data storage unit.

5. A method for operating a power supply system having electronic electricity meters, wherein, in replacement of periodic calibration measurements taken on a random basis on individual electricity meters, a continuous or periodical internal verification signal detection and processing in the entirety of electricity meters is performed and the results thereof are internally stored and/or sent to a central unit of the power supply system and/or are utilized for executing an internal control operation in the electricity meters, wherein the internal verification signal detection and processing comprises a first threshold discrimination for detecting a shortfall or excess of a predetermined threshold value of the difference between a measurement signal of the intended measuring function and the processed measurement signals of verification measurement means for providing a verification signal among a first and a second verification signal, wherein the power supply system is realized as a four conductor supply system, and the verification signal detection comprises measuring the conductor currents $i_{L1}(t)$, $i_{L2}(t)$, $i_{L3}(t)$ and the neutral conductor current $i_N(t)$ and the conductor voltages $u_{L1}(t)$, $u_{L2}(t)$, $u_{L3}(t)$ and the two conductor-to-conductor voltages $u_{L1L2}(t)$, $u_{L3L1}(t)$, and wherein a processing algorithm based on the "principle of two equations" is processed using the measurement signals of the current measuring means and the voltage measuring means and the equation for the active power P(t), P'(t):

$$P(t) = \int_t^{t+kT} u_{L1}(t) i_{L1}(t)dt + u_{L2}(t)i_{L2}(t)dt + u_{L3}(t)i_{L3}(t)dt \qquad [1.1]$$

$$P'(t) = \int_t^{t+kT} -u_{L1}(t) i_N(t)dt + u_{L1L2}(t)i_{L2}(t)dt + u_{L3L1}(t)i_{L3}(t)dt \quad [1.2]$$

and a threshold discrimination for detecting the shortfall or excess of a predetermined threshold value $\varepsilon_P$ is performed for the differential amount $\Delta P$ from both of the equations according to

$$P(t) - P'(t) = \Delta P \geq \varepsilon_p \qquad [1.3]$$

for providing a verification signal among the first and the second verification signal depending on the shortfall or excess.

**Revendications**

1. Compteur de courant électronique (1), lequel présente des moyens de mesure de vérification internes et des moyens de traitement internes associés à ceux-ci côté entrée qui ne sont pas nécessaires pour une fonction de mesure conforme à l'utilisation prévue et sont constitués de telle façon qu'un signal de vérification déterminé à partir de signaux de mesure des moyens de mesure vérifie ou ne vérifie pas l'exactitude de la fonction de mesure conforme à l'utilisation prévue, et comprend, connectée en aval des moyens de traitement associés aux moyens de mesure de vérification, une unité de mémoire pour la mise en mémoire du signal de vérification et/ou unité d'émission pour l'émission du signal de vérification et/ou unité de commande pour le lancement d'une opération de commande dans le compteur de courant en fonction du signal de vérification, sachant que les moyens de traitement présentent un premier discriminateur de valeur seuil (15e) pour la saisie du franchissement par le bas ou par le haut d'une valeur seuil prédéterminée de la différence entre un signal de mesure de la fonction de mesure conforme à l'utilisation prévue et les signaux de mesure traités des moyens de mesure de vérification pour la mise à disposition d'un signal de vérification parmi un premier et d'un deuxième signal de vérification, sachant que les moyens de mesure de vérification comprennent des moyens de mesure de courant (5a, 5b, 5c, 5d), en particulier une résistance en dérivation, pour la saisie des courants de conducteur $i_{L1}(t)$, $i_{L2}(t)$, $i_{L3}(t)$ et du courant de conducteur neutre $i_N(t)$ ainsi que des moyens de mesure de tension (7a, 7b, 7c, 7d, 7e), en particulier respectivement un diviseur à résistance, pour la saisie des tensions de conducteur $u_{L1}(t)$, $u_{L2}(t)$, $u_{L3}(t)$ et des tensions conducteur-conducteur $u_{L1L2}(t)$, $u_{L3L1}(t)$ des conducteurs (L1, L2, L3) transporteurs de courant d'un système à quatre conducteurs (3) et sachant que, dans les moyens de traitement, un algorithme de traitement est implémenté selon le « principe de deux équations » moyennant les signaux de mesure des moyens de mesure de courant et des moyens de mesure de tension, et des équations pour la puissance active P(t), P'(t) :

$$P(t) = \int_t^{t+kT} u_{L1}(t)\, l_{L1}(t)\, dt + u_{L2}(t)\, l_{L2}(t)\, dt + u_{L3}(t)\, l_{L3}(t)\, dt \qquad [1.1]$$

$$P'(t) = \int_t^{t+kT} -u_{L1}(t)\, i_N(t)\, dt + u_{L1L2}(t)\, l_{L2}(t)\, dt + u_{L3L1}(t)\, l_{L3}(t)\, dt \qquad [1.2]$$

et le premier discriminateur de valeur seuil pour la saisie du franchissement par le bas ou par le haut d'une valeur seuil $\varepsilon_P$ prédéterminée pour le montant de différence $\Delta P$ est constitué à partir des deux équations conformément à

$$P(t) - P'(t) = \Delta P \geq \varepsilon_P \qquad [1.3]$$

pour la mise à disposition du signal de vérification parmi le premier et le deuxième signal de vérification en fonction du franchissement par le bas ou par le haut.

2. Système d'alimentation en courant (100) comprenant une pluralité de compteurs de courant électroniques (1) selon la revendication 1 et une unité centrale de mémoire de données pour la mise en mémoire des signaux de vérification acquis dans les compteurs de courant en association avec le compteur de courant respectif et le moment de leur acquisition.

3. Système d'alimentation en courant selon la revendication 2, sachant que, dans les compteurs de courant, une unité d'émission (19) pour l'émission des signaux de vérification et, au niveau de l'unité centrale de mémoire de données, une unité de réception (103a) pour la réception des signaux de vérification, en particulier en temps réel ou en temps quasi-réel, sont prévues.

4. Système d'alimentation en courant selon la revendication 2 ou 3, sachant qu'une unité d'affichage (103c), en particulier à fonction d'affichage d'alarme, est associée à l'unité centrale de mémoire de données pour l'affichage, spécifiquement à un compteur, du signal de vérification émis, en particulier en réponse à un signal de vérification indiquant l'inexactitude de la fonction de mesure conforme à l'utilisation prévue.

5. Procédé d'exploitation d'un système d'alimentation en courant à compteurs de courant électroniques, sachant que, en remplacement de mesures d'étalonnage périodiques aléatoires sur des compteurs de courant individuels, une saisie et un traitement internes continus ou périodiques de signal de vérification sont exécutés dans la totalité des compteurs de courant et leurs résultats sont mis en mémoire en interne et/ou envoyés à une centrale du système d'alimentation en courant et/ou utilisés pour l'exécution d'une opération de commande interne dans les compteurs de courant, sachant que la saisie et le traitement internes de signal de vérification comprend une première discrimination de valeur seuil pour la saisie d'un franchissement par le bas ou par le haut d'une valeur seuil prédéterminée de la différence entre un signal de mesure de la fonction de mesure conforme à l'utilisation prévue et des signaux de mesure traités provenant de moyens de mesure de vérification pour la mise à disposition d'un signal de vérification parmi un premier et d'un deuxième signal de vérification, sachant que le système d'alimentation en courant est exécuté comme système d'alimentation à quatre conducteurs et la saisie de signal de vérification comprend la mesure des courants de conducteur $i_{L1}(t)$, $i_{L2}(t)$, $i_{L3}(t)$ et du courant de conducteur neutre iN(t) ainsi que des tensions de conducteur $u_{L1}(t)$, $u_{L2}(t)$, $U_{L3}(t)$ et des deux tensions conducteur-conducteur $U_{L1L2}(t)$, $U_{L3L1}(t)$ et sachant qu'un algorithme de traitement est réalisé selon le « principe de deux équations » moyennant les signaux de mesure des moyens de mesure de courant et des moyens de mesure de tension, et des équations pour la puissance active P(t), P'(t) :

**EP 2 487 502 B1**

$$P(t) = \int_t^{t+kT} u_{L1}(t)\, l_{L1}(t)\, dt + u_{L2}(t) l_{L2}(t)\, dt + u_{L3}(t) l_{L3}(t)\, dt \qquad [1.1]$$

$$P'(t) = \int_t^{t+kT} -u_{L1}(t)\, l_N(t)\, dt + u_{L1L2}(t) l_{L2}(t)\, dt + u_{L3L1}(t) l_{L3}(t)\, dt \quad [1.2]$$

et une discrimination de valeur seuil pour la saisie du franchissement par le bas ou par le haut d'une valeur seuil $\varepsilon_P$ prédéterminée pour le montant de différence $\Delta P$ est exécutée à partir des deux équations conformément à

$$P(t) - P'(t) = \Delta P \geq \varepsilon_P \qquad [1.3]$$

pour la mise à disposition d'un signal de vérification parmi premier et le deuxième signal de vérification en fonction du franchissement par le bas ou par le haut.

**10**

Fig. 1

Fig. 2

Fig. 3